# EUROPEAN PATENT APPLICATION

(11) **EP 4 422 020 A1**
(43) Date of publication of application: **28.08.2024**
(21) Application number: 22922688.1
(22) Date of filing: 26.01.2022
(51) Int. Cl.: H02J 7/00

(54) **BATTERY MANAGEMENT METHOD AND BATTERY MANAGEMENT APPARATUS**

(71) Applicant: Contemporary Amperex Technology Co., Limited, Ningde, Fujian 352100 (CN)
(72) Inventor: ZHANG, Chuanhui, Ningde, Fujian 352100 (CN); LI, Xiangtao, Ningde, Fujian 352100 (CN); LI, Bao, Ningde, Fujian 352100 (CN); WU, Kai, Ningde, Fujian 352100 (CN)
(74) Representative: Holt, Lucy Rose
(86) International application number: PCT/CN2022/074115
(87) International publication number: WO 2023/141838

(57) **Abstract**

A battery management method, a battery management apparatus, and a battery system. The battery management method is applied to a battery management apparatus (20), so as to manage a battery apparatus (10). The battery management apparatus (20) comprises a connection state conversion apparatus (200), wherein a contact of the connection state conversion apparatus (200) is connected to two battery packs of the battery apparatus (10). The method comprises: acquiring a working environment voltage of a battery apparatus (10); and controlling, according to the working environment voltage, a connection state conversion apparatus (200) to switch from a first connection state to a second connection state. The technical problem of a battery apparatus (10) being incompatible with different voltage platforms is expected to be solved.

## Description

### TECHNICAL FIELD

Embodiments of the present disclosure relate to the field of batteries technologies, and more particularly, relates to a battery management method and a battery management device.

### BACKGROUND

With the increasing energy shortages and environmental pollution in modern society, electric vehicles have been widely recognized as a new source of energy for vehicles. Conventional household electric vehicles are designed and developed based on a 400V voltage platform and have rapidly taken over the market. Batteries, the motors and the related system components of the electric vehicles are all suitable for the 400V voltage platform. Thus, charging devices adapted to the 400V voltage platform are provided in the market to charge the electric vehicles.

With the increasing requirements on the endurance mileage of an electric vehicle and the increase of the freight demand and the passenger transport demand based on the electric vehicle, a battery capacity of the electric vehicle is becoming larger and larger, and a charging time is becoming longer and longer, the electric vehicles and the charging devices based on the 800V voltage platform are provided accordingly, the charging time is greatly shortened. However, a charging device based on the 400V voltage platform cannot charge an electric vehicle based on the 800V voltage platform, an electric vehicle based on the 400V voltage platform cannot be charged by using a charging device based on the 800V voltage platform. Moreover, a battery device based on the 400V voltage platform cannot supply power to system components (e.g., a motor) based on the 800V voltage platform, and system components (e.g., the motor) based on the 400V voltage platform cannot be compatible with a battery device based on the 800V voltage platform.

### SUMMARY

In accordance with the first aspect, a battery management device configured to manage a battery device is provided in the embodiments of the present disclosure. Where the battery management device includes: a control device and a connection state transition device; the connection state transition device includes a first pair of contacts, a second pair of contacts, and a third pair of contacts. One contact in the first pair of contacts is configured to connect to a positive electrode of a first battery pack of the battery device, and the other contact in the first pair of contacts is configured to connect to a negative electrode of a second battery pack of the battery device. One contact in the second pair of contacts is configured to connect to the positive electrode of the first battery pack, and the other contact in the second pair of contacts is configured to connect to a positive electrode of the second battery pack. One contact in the third pair of contacts is configured to connect to a negative electrode of the first battery pack, and the other contact in the third pair of contacts is configured to connect to the negative electrode of the second battery pack. The control device is configured to control the connection state transition device to transition from a first connection state to a second connection state. The first connection state includes: the first pair of contacts is switched on, the second pair of contacts is switched off, and the third pair of contacts is switched off; the second connection state comprises: the first pair of contacts is switched off, the second pair of contacts is switched on, and the third pair of contacts is switched on. Alternatively, the first connection state comprises: the first pair of contacts is switched off, the second pair of contacts is switched on, and the third pair of contacts is switched on; the second connection state comprises: the first pair of contacts is switched on, the second pair of contacts is switched off, and the third pair of contacts is switched off.

In some possible embodiments, the control device is further configured to obtain operating environment information of the battery device. The control device is further configured to control the connection state transition device to transition from the first connection state to the second connection state according to the operating environment information.

In some possible embodiments, the operating environment information includes an operating environment voltage, a nominal voltage of the first battery pack is the same as a nominal voltage of the second battery pack. The control device is further configured to control the connection state transition device to transition from the first connection state to the second connection state when determining that the operating environment voltage matches the nominal voltage.

In some possible embodiments, the operating environment information comprises an operating environment voltage, and a nominal voltage of the first battery pack is the same as a nominal voltage of the second battery pack. The control device is further configured to control the connection state transition device to transition from the first connection state to the second connection state when determining that the operating environment voltage matches twice of the nominal voltage.

In some possible embodiments, the operating environment voltage includes an operating voltage of the charging device, the negative electrode of the first battery pack and the positive electrode of the second battery pack are connected to the charging device. The control device is further configured to control the charging device to charge the battery device.

In some possible embodiments, the operating environment voltage includes an operating voltage of an electrical device, the negative electrode of the first battery pack and the positive electrode of the second battery pack are connected to the electrical device; the control device is further configured to control the battery device to supply power to the electrical device.

In some possible embodiments, the connection state transition device includes a detection unit and a switching on-off unit. The control device is further configured to transmit a control signal to the connection state transition device. The detection unit is configured to drive the switching on-off unit to move from a first position to a second position in response to detecting the control signal. When the switching on-off unit is located at the first position, the connection state transition device is in the first connection state. When the switching on-off unit is located at the second position, the connection state transition device is in the second connection state.

In accordance with the second aspect, a battery system is provided, the battery system includes the battery management device in the first aspect and all possible embodiments in the first aspect.

In accordance with the third aspect, a battery management method is provided, the battery management method is applied to a battery management device to realize management of a battery device. Where the battery management device includes a connection state transition device. The connection state transition device includes a first pair of contacts, a second pair of contacts, and a third pair of contacts. One contact in the first pair of contacts is configured to connect to a positive electrode of a first battery pack of the battery device, the other contact in the first pair of contacts is configured to connect to a negative electrode of a second battery pack of the battery device. One contact in the second pair of contacts is configured to connect to the positive electrode of the first battery pack, the other contact in the second pair of contacts is configured to connect to a positive electrode of the second battery pack. One contact in the third pair of contacts is configured to connect to a negative electrode of the first battery pack, and the other contact in the third pair of contacts is configured to connect to the negative electrode of the second battery pack. A first connection state of the connection state transition device includes: the first pair of contacts is switched on, the second pair of contacts is switched off, and the third pair of contacts is switched off; the second connection state of the connection state transition device includes: the first pair of contacts is switched off, the second pair of contacts is switched on, and the third pair of contacts is switched on. As an alternative, the first connection state includes: the first pair of contacts is switched off, the second pair of contacts is switched on, and the third pair of contacts is switched on; the second connection state includes: the first pair of contacts is switched on, the second pair of contacts is switched off, and the third pair of contacts is switched off. The method includes: obtaining operating environment information of the battery device; and controlling the connection state transition device to transition from the first connection state to the second connection state according to the operating environment information.

In some possible embodiments, the operating environment information includes an operating environment voltage, and a nominal voltage of the first battery pack is the same as a nominal voltage of the second battery pack. Said controlling the connection state transition device to transition from the first connection state to the second connection state according to the operating environment information includes: controlling the connection state transition device to transition from the first connection state to the second connection state, when determining that the operating environment voltage matches the nominal voltage.

In some possible embodiments, the operating environment information includes an operating environment voltage, and a nominal voltage of the first battery pack is the same as a nominal voltage of the second battery pack. Said controlling the connection state transition device to transition from the first connection state to the second connection state according to the operating environment information includes: controlling the connection state transition device to transition from the first connection state to the second connection state, when determining that the operating environment voltage matches twice of the nominal voltage.

In some possible embodiments, the operating environment voltage includes an operating voltage of the charging device, a negative electrode of the first battery pack and a positive electrode of the second battery pack are connected to the charging device. After controlling the connection state transition device to transition from the first connection state to the second connection state, the method further includes: controlling the charging device to charge the battery device.

In some possible embodiments, the operating environment voltage includes an operating voltage of an electrical device, a negative electrode of the first battery pack and a positive electrode of the second battery pack are connected to the electrical device. After controlling the connection state transition device to transition from the first connection state to the second connection state, the method further comprises: controlling the battery device to supply power to the electrical device.

In some possible embodiments, the connection state transition device includes a detection unit and a switching on-off unit. Said controlling the connection state transition device to transition from the first connection state to the second connection state according to the operating environment information comprises: sending a control signal to the connection state transition device according to the operating environment information, in order that the detection unit drives the switching on-off unit to move from a first position to a second position in response to detecting the control signal. When the switching on-off unit is located at the first position, the connection state transition device is in the first connection state. When the switching on-off unit is located at the second position, the connection state transition device is in the second connection state.

In accordance with the fourth aspect, a computer device is provided. The computer device includes a processor and a memory. The memory stores a computer instruction, the processor is configured to execute the computer instruction so as to cause the computer device to implement the battery management method according to the third aspect and all possible embodiments of the third aspect.

In accordance with the fifth aspect, a computer-readable storage medium is provided. The computer-readable storage medium is configured to store a computer instruction, that, when executed by a computer device, causes the computer device to implement the battery management method according to the third aspect and all possible embodiments of the third aspect.

In accordance with the sixth aspect, a connection state transition device is provided. The connection state transition device includes: a first pair of contacts, a second pair of contacts, a third pair of contacts, and a connection control device. One contact in the first pair of contacts is configured to connect to a positive electrode of the first battery pack, and the other contact in the first pair of contacts is configured to connect to a negative electrode of the second battery pack. One contact in the second pair of contacts is configured to connect to the positive electrode of the first battery pack, and the other contact in the second pair of contacts is configured to connect to a positive electrode of the second battery pack. One contact in the third pair of contacts is configured to connect to a negative electrode of the first battery pack, and the other contact in the third pair of contacts is configured to connect to the negative electrode of the second battery pack. The connection control device is configured to cause the connection state transition device to transition from the first connection state to the second connection state in response to detecting a control signal. The first connection state includes: the first pair of contacts is switched on, the second pair of contacts is switched off, and the third pair of contacts is switched off; the second connection state includes: the first pair of contacts is switched off, the second pair of contacts is switched on, and the third pair of contacts is switched on. Alternatively, the first connection state includes: the first pair of contacts is switched off, the second pair of contacts is switched on, and the third pair of contacts is switched on; the second connection state includes: the first pair of contacts is switched on, the second pair of contacts is switched off, and the third pair of contacts is switched off.

In accordance with the seventh aspect, a battery device is provided. The battery device includes the connection state transition device according to the sixth aspect and all possible embodiments of the sixth aspect, and further includes the first battery pack and the second battery pack mentioned in the sixth aspect.

### DESCRIPTION OF THE DRAWINGS

In order to describe the embodiments of the present disclosure more clearly, a brief introduction regarding the accompanying drawings that need to be used for describing the embodiments of the present disclosure is given below. It will be apparent that the accompanying drawings described below are merely some embodiments of the present disclosure, a person of ordinary skill in the art may also obtain other drawings according to the current drawings without paying creative efforts.
FIG. 1 illustrates a schematic diagram of an application scenario of a battery management device provided in one or multiple embodiments of the present disclosure;
FIG. 2 illustrates a schematic diagram of an operating condition of the battery management device provided in one or multiple embodiments of the present disclosure;
FIG. 3 illustrates a schematic diagram of an operating condition of another battery management device provided in one or multiple embodiments of the present disclosure;
FIG. 4 illustrates a schematic diagram of an operating condition of one connection state transition device provided in one or multiple embodiments of the present disclosure;
FIG. 5 illustrates a schematic diagram of an operating condition of another connection state transition device provided in one or multiple embodiments of the present disclosure;
FIG. 6 illustrates a schematic flow diagram of a battery management method provided in one or multiple embodiments of the present disclosure;
FIG. 7 illustrates a schematic block diagram of a computer device provided in one or multiple embodiments of the present disclosure.

### DETAILED DESCRIPTION OF EMBODIMENTS

In order to make the objective, the technical solutions and the advantages of the present disclosure be clearer, the technical solutions in the embodiments of the present disclosure will be described clearly with reference to accompanying drawings in the embodiments. It will be apparent that, the embodiments described below are only some embodiments of the present disclosure rather than all of the embodiments. Based on the embodiments in the present disclosure, some other embodiments, which are obtained by a person of ordinary skill in the art without paying creative labor, are all included in the protection scope of the present disclosure.

Unless otherwise defined, all technical and scientific terms used herein have the same meaning as normally understood by the person skilled in the art. The terms used in the specification of the present disclosure are only for the purpose of describing specific embodiments and are not intended to limit the present disclosure. The terms "includes" and "has" in the description and claims of the present disclosure and in the accompanying illustrations above, and any variation thereof, are intended to cover non-exclusive inclusion. The technical terms "first", "second", etc., in the description and the claims of the present disclosure and the accompanying figures are only used to distinguish different objects, rather than describing a particular order or primary or secondary relationship.

Reference to "embodiments" in the present disclosure means that a particular feature, structure or characteristic described with reference to the embodiments may be included in at least one embodiment of the present disclosure. The occurrence of the phrase at various parts in the specification does not necessarily refer to the same embodiment, nor is it a separate or alternative embodiment being mutually exclusive with other embodiments. It is understood, both explicitly and implicitly, by those skilled in the art that the embodiments described herein may be combined with other embodiments.

In the description of the present disclosure embodiment, unless additional explicit stipulation and limitation are provided, terms such as "mount", "connect with each other", "connect", "attach", etc., should be generalizedly interpreted. For example, "connect" can be interpreted as being fixedly connected, detachably connected, or connected integrally. "Connect" can be further interpreted as being directly connected or indirectly connected through intermediary, and can be internal communication between two components. For the person of ordinary skill in the art, the specific meanings of the aforementioned terms in the present disclosure can be interpreted according to specific conditions.

In the present application, the term "and/or" is only used to describe an association relationship of an associated object, represents that there may be three relationships. For example, A and/or B may represent three conditions: A exists alone, A and B coexist, B exists alone. In addition, the character "/" generally indicates that there is a "or" relationship between two continuous associated objects.

In the present disclosure, "a plurality of" means more than two (including two). Similarly, "a plurality of groups" means more than two groups (including two groups), and "a plurality of sheets" means more than two sheets (including two sheets).

A battery device includes a battery that provides electrical energy for an electrical devices or a load device. The battery device may include a storage battery or a secondary battery. Regarding the types of batteries, the battery device may be a lithium ion battery, a lithium metal battery, a lead-acid battery, a nickel-chromium battery, a nickel-metal hydride battery, a lithium-sulfur battery, a lithium-air battery, a sodium-ion battery, etc., the types of the batteries are not specifically limited in the embodiments of the present disclosure. Regarding the capacity of the battery, the battery device may include a battery cell/cell, battery group, and/or battery pack. The battery device may include a battery management device. For example, the battery includes a battery management system (BMS), and the battery management device may be configured to perform control management operations, such as safety monitoring, collection, and configuration parameters, control of charging and discharging, etc., on the battery device. The functions of the battery management device are not specifically limited in the embodiments of the present disclosure.

A charging device, for example, the charging device includes a charging pile or a charger, is configured to charge the battery device. The charging device may output a charging power according to the charging requirement of the BMS to charge the battery device. For example, the charging device may output a voltage and a current according to the required voltage and the required current sent by the BMS, and charge the battery device with the participation of the BMS.

Electrical devices, which include various electrical devices for acquiring electrical energy from the battery device, and include but are not limited to, motors, vehicles, ships, and aircrafts, etc. For examples, a motor of a hybrid vehicle is connected to the battery device and obtain electric energy from the battery device to achieve a driving capability. The electrical devices are not particularly defined in the embodiments of the present disclosure.

As a common scenario, the charging device charges the battery device, and the battery device provides electric energy for the electrical device. However, in some special scenarios, a charging input of the charging device may not match with the battery device, and a power output of the battery device may not be compatible with the electrical device. For example, a charging pile based on a 400V voltage platform cannot charge an electric vehicle based on an 800V voltage platform, an electric vehicle based on a 400V voltage platform cannot be charged by a charging pile based on an 800 volt voltage platform, and a battery device based on a 400V voltage platform cannot supply power to system components such as a motor based on an 800 volt voltage platform, and system components such as a motor based on a 400 volt voltage platform cannot be compatible with a battery device based on an 800 volt voltage platform.

Aiming at the conditions mentioned above, the embodiments of the present disclosure provide a battery management device, which aims at improving the compatibility of the battery device in terms of charging input and/or power output, thereby solving the technical problem that the battery device cannot be compatible with different voltage platforms.

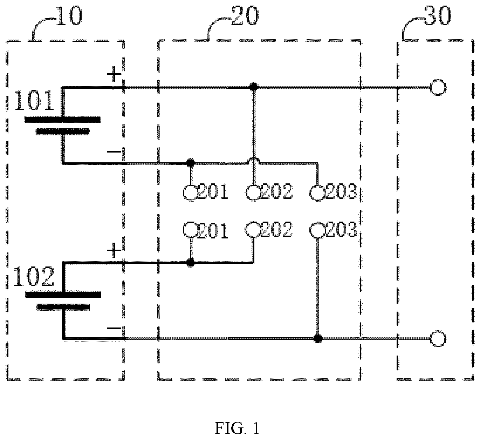

FIG. 1 illustrates a schematic diagram of an application scenario of a battery management device according to one or multiple embodiments of the present disclosure. A battery device 10, a battery management device 20 and a charging device/an electrical device 30 are included in FIG. 1. Where, the battery device 10 includes a first battery pack 101 and a second battery pack 102. The first battery pack 101 and the second battery pack 102 may be connected in series or in parallel, and the first battery pack 101 and the second battery pack 102 are connected to the charging device/the electrical device 30 (in this embodiment of the present disclosure, the electrical device 30 may be a charging device, and may also be power utilization equipment), thereby implementing power supply for the electrical device or charging through the charging device. In this embodiment of the present disclosure, for example, the battery pack is composed of a plurality of cells connected in series and/or in parallel and includes a positive electrode and a negative electrode. The charging device is, for example, a charging pile or a charging gun. The electrical device is, for example, a motor or a vehicle, a ship, an aircraft, etc. As can be understood by a person skilled in the art, FIG. 1 is the schematic diagram of the application scenario of the battery management device according to one embodiment of the present disclosure, some other electrical components may also be integrated in the application scenario shown in FIG. 1. For example, a positive electrode and a negative electrode of the battery device may be respectively connected to a main positive switch, a main negative switch or a relay as required. The integration of other electrical components is not limited in the embodiments of the present disclosure.

The battery management device 20 includes a control device 210 (not shown in FIG. 1) and a connection state transition device 200 (not shown in FIG. 1). The connection state transition device 200 includes a first pair of contacts 201, a second pair of contacts 202, and a third pair of contacts 203. One contact in the first pair of contacts 201 is configured to connect to a positive electrode of the first battery pack 101 of the battery device 10, and the other contact in the first pair of contacts 201 is configured to connect to a negative electrode of the second battery pack 102 of the battery device 10. One contact the second pair of contacts 202 is configured to connect to the positive electrode of the first battery pack 101, and the other contact the second pair of contacts 202 is configured to connect to a positive electrode of the second battery pack 102. One contact in the third pair of contacts 203 is configured to connect to the negative electrode of the first battery pack 101, and the other contact in the third pair of contacts 203 is configured to connect to the negative electrode of the second battery pack 102. For example, one contact may be connected to the positive electrode or the negative electrode of the battery pack through a wire. Thus, there is an electrical connection between the positive electrode or the negative electrode of the battery pack and this contact.

The connection state transition device 200 of the battery management device 20 includes a first connection state and a second connection state. In one optional embodiment, the first connection state includes: the first pair of contacts 201 is switched on, the second pair of contacts 202 is switched off, the third pair of contacts 203 is switched off. The second connection state includes: the first pair of contacts 201 is switched off, the second pair of contacts 202 is switched on, the third pair of contacts 203 is switched on. In another optional embodiment, the first connection state includes: the first pair of contacts 201 is switched off, the second pair of contacts 202 is switched on, the third pair of contacts 203 is switched on. The second connection state includes the first pair of contacts 201 is switched on, the second pair of contacts 202 is switched off, the third pair of contacts 203 is switched off. The person skilled in the art can understand that one pair of contacts is switched on means that there is an electrical connection between the pair of contacts. For example, current may flow from one contact in the pair of contacts to the other contact in the pair of contacts, a pair of contacts is switched off means that there is no electrical connection between the pair of contacts. For example, current cannot flow from one contact in the pair of contacts to the other contact in the pair of contacts.

The control device 210 of the battery management device 20 is configured to control the connection state transition device 200 to transition from the first connection state to the second connection state. As an example, the control device 210 may be a functional unit implemented by software and/or hardware. For example, the control device 210 includes a processor or a processing unit which may be coupled with a memory and execute an instruction stored in the memory so as to implement the functions of managing and/or controlling the battery device. For another example, the control device 210 may include a control circuit for implementing the functions of managing and/or controlling the battery device. The control device 210 may serve as a part of the BMS, or serve as the BMS itself, and implement the functions such as the management and/or the control. In one or multiple embodiments of the present disclosure, the control device 210 controls the connection state transition device 200 to transition from the first connection state to the second connection state. For example, the control device 210 may send a control signal to the connection state transition device 200, in order that the connection state transition device 200 transitions from the first connection state to the second connection state in response to detecting the control signal. It should be noted that, the types and implementation manners of the control signal are not limited in the embodiments of the present disclosure. For example, transmission of the control signal may be implemented by sending a control instruction, sending a high level, sending a low level, energizing, deenergizing, etc.

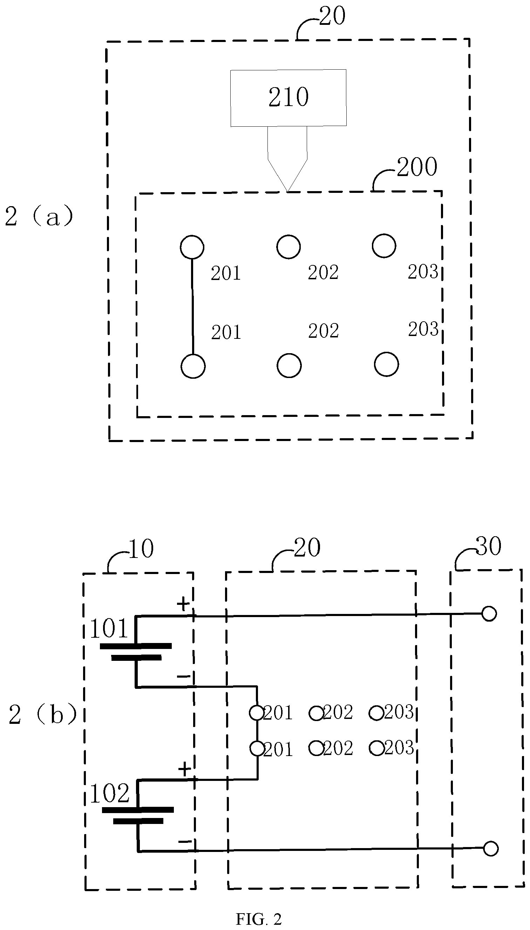

FIG. 2 illustrates an operating state of the connection state transition device 200 of the battery management device 20. Where FIG. 2(a) illustrates a connection state of the connection state transition device 200 of the battery management device 20, FIG. 2 (b) illustrates a diagram of an operating state of the battery management device 20 in the application scenario shown in FIG. 1 when the battery management device 20 is in the connection state. In FIG. 2, the connection states of the connection state transition device 200 includes: the first pair of contacts 201 is switched on, the second pair of contacts 202 is switched off, and the third pair of contacts 203 is switched off. Since the second pair of contacts 202 is switched off, and the third pair of contacts 203 is switched off, in order to facilitate understanding of the embodiments of the present disclosure, circuit lines that connect the second pair of contacts 202 with the third pair of contacts 203 are not shown in FIG. 2(b).

Referring to FIG. 2 (a), the battery management device 20 includes a connection state transition device 200 and a control device 210. The connection state transition device 200 includes a first pair of contacts 201, a second pair of contacts 202, and a third pair of contacts 203. In the FIG. 2(a), the connection state of the connection state transition device 200 includes: the first pair of contacts 201 is switched on, the second pair of contacts 202 is switched off, the third pair of contacts 203 is switched off. Thus, an electrical connection or a path exists between the two contacts of the first pair of contacts 201. For example, current may flow from one contact in the first pair of contacts 201 to the other contact in the first pair of contacts 201, however, the second pair of contacts 202 is switched off, there is no path between the two contacts of the second pair of contacts 202, current cannot flow from one contact the second pair of contacts 202 to the other contact the second pair of contacts 202. The third pair of contacts 203 is also in a switched off state, there is no path between the two contacts of the third pair of contacts 203, and current cannot flow from one contact in the third pair of contacts 203 to the other contact in the third pair of contacts 203. Referring to FIG. 2 (b), since one contact in the first pair of contacts 201 is connected to the negative electrode of the first battery pack 101 of the battery device 10, the other contact in the first pair of contacts 201 is connected to the positive electrode of the second battery pack 102 of the battery device 10. Thus, when the first pair of contacts 201 is switched on, the second pair of contacts 202 and the third pair of contacts 203 are switched off, the negative electrode of the first battery pack 101 of the battery device 10 and the positive electrode of the second battery pack 102 are connected through the first pair of contacts 201, the first battery pack 101 and the second battery pack 102 of the battery device 10 are connected in series. As shown in FIG. 2 (b), the positive electrode of the first battery pack 101 and the negative electrode of the second battery pack 102 are respectively connected to the charging device/the electrical device 30. Thus, when the connection state transition device 200 is in the connection state (i.e., the first pair of contacts 201 is switched on, the second pair of contacts 202 is switched off, the third pair of contacts 203 is switched off) as shown in FIG. 2, the first battery pack 101 and the second battery pack 102 are connected in series so as to supply power to the electrical device 30; or alternatively, the first battery pack 101 and the second battery pack 102 are connected in series so as to obtain electric energy from the charging device 30.

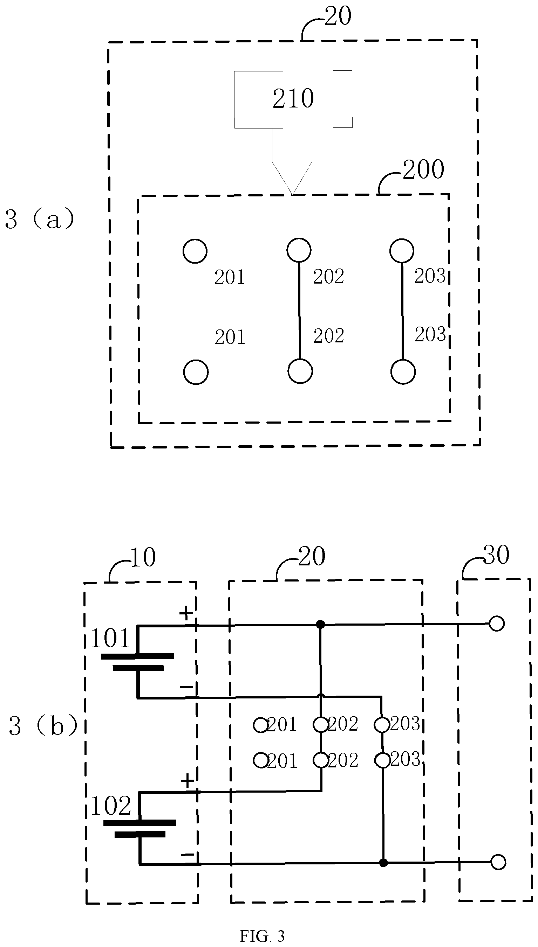

FIG. 3 illustrates a schematic diagram of an operating state of another battery management device provided by one or multiple embodiments of the present disclosure. Where, FIG. 3 (a) illustrates another connection state of the connection state transition device 200 of the battery management device 20, and FIG. 3 (b) illustrates an operating state diagram of the battery management device 20 in the application scenario shown in FIG. 1 when the battery management device 20 is in the aforementioned connection state. In FIG. 3, the connection state of the connection state transition device 200 includes: the first pair of contacts 201 is switched off, the second pair of contacts 202 is switched on, and the third pair of contacts 203 is switched on. Since the first pair of contacts 201 is switched off, for the convenience of interpretation of the embodiments of the present disclosure, a circuit line that is connected to the first pair of contacts 201 is not shown in FIG. 3 (b).

Referring to FIG. 3 (a), the battery management device 20 includes a connection state transition device 200 and a control device 210. The connection state transition device 200 includes a first pair of contacts 201, a second pair of contacts 202, and a third pair of contacts 203. In FIG. 3(a), the connection states of the connection state transition device 200 includes: the first pair of contacts 201 is switched off, the second pair of contacts 202 is switched on, the third pair of contacts 203 is switched on. Thus, the two contacts of the first pair of contacts 201 are switched off, a path does not exist between the two contacts of the first pair of contacts 201, and current cannot flow from one contact in the first pair of contacts 201 to the other contact in the first pair of contacts. However, the second pair of contacts 202 is switched on, thus, an electrical connection or a path exists between the two contacts of the second pair of contacts 202. For example, current may flow from one contact in the second pair of contacts 202 to the other contact in the second pair of contacts 202. The third pair of contacts 203 is also in a switched on state, an electrical connection or a path exists between the two contacts of the third pair of contacts 203. For example, current may flow from one contact in the third pair of contacts 203 to the other contact in the third pair of contacts 203. With reference to FIG. 3 (b), since one contact in the second pair of contacts 202 is connected to the positive electrode of the first battery pack 101, the other contact in the second pair of contacts 202 is connected to the positive electrode of the second battery pack 201, one contact in the third pair of contacts 203 is connected to the negative electrode of the first battery pack 101, the other contact in the third pair of contact 203 is connected to the negative electrode of the second battery pack 201. Thus, when the first pair of contacts 201 is switched off, the second pair of contacts 202 and the third pair of contacts 203 are switched on, the positive electrode of the first battery pack 101 and the positive electrode of the second battery pack 102 of the battery device 10 are connected through the second pair of contacts 202, and the negative electrode of the first battery pack 101 and the negative electrode of the second battery pack 102 of the battery device 10 are connected through the third pair of contacts 203, and the first battery pack 101 and the second battery pack 102 of the battery device 10 are connected in parallel. As shown in FIG. 3 (b), the positive electrode of the first battery pack 101 and the negative electrode of the second battery pack 102 are respectively connected to the charging device/the electrical device 30. Thus, when the connection state transition device 200 is in the connection state (i.e., the first pair of contacts 201 is switched off, the second pair of contacts 202 is switched on, the third pair of contacts 203 is switched on) as shown in FIG. 3, the first battery pack 101 and the second battery pack 102 are connected in parallel so as to supply power to the electrical device 30; or alternatively, the first battery pack 101 and the second battery pack 102 are connected in series so as to obtain electric energy from the charging device 30.

Optionally, the first connection state includes the connection state shown in FIG. 2 (a), that is, the first pair of contacts 201 of the connection state transition device 200 is switched on, the second pair of contacts 202 and the third pair of contacts 203 of the connection state transition device 200 are switched off. The second connection state includes the connection state shown in FIG. 3 (a), that is, the first pair of contacts 201 of the connection state transition device 200 is switched off, the second pair of contacts 202 and the third pair of contacts 203 of the connection state transition device 200 are switched on. For example, the connection state transition device 200 of the battery management device 20 is in the first connection state as shown in FIG. 2 (a), regarding the connection state transition device 200 being in the first connection state, reference can be made to the relevant descriptions of FIG. 2. In this condition, the first battery pack 101 and the second battery pack 102 of the battery device 10 are connected in series, and the first battery pack 101 and the second battery pack 102 supply power to the electrical device 30 by connecting in series; or alternatively, the first battery pack 101 and the second battery pack 102 obtain electric energy from the charging device 30 by connecting in series. In this way, the control device 210 may send a control signal to the connection state transition device 200, in order that the connection state transition device 200 transitions from the first connection state shown in FIG. 2 (a) to the second connection state shown in FIG. 3 (a) in response to detecting that the control signal, regarding the conversion of the connection state transition device 200, reference can be made to the relevant descriptions of FIG. 3. The first battery pack 101 and the second battery pack 102 of the battery device 10 are connected in parallel after conversion, and the first battery pack 101 and the second battery pack 102 are connected in parallel so as to supply power to the electrical device 30; or alternatively, the first battery pack 101 and the second battery pack 102 are connected in series so as to obtain electric energy from the charging device 301.

Optionally, the first connection state includes the connection state shown in FIG. 3 (a), that is, the first pair of contacts 201 of the connection state transition device 200 is switched off, the second pair of contacts 202 is switched on, the third pair of contacts 203 is switched on. The second connection state includes the connection state shown in FIG. 2 (a), that is, the first pair of contacts 201 of the connection state transition device 200 is switched on, the second pair of contacts 202 and the third pair of contacts 203 of the connection state transition device 200 are switched off. For example, the connection state transition device 200 of the battery management device 20 is in the first connection state shown in FIG. 3 (a), with reference to the relevant descriptions of FIG. 3, in this condition, the first battery pack 101 and the second battery pack 102 of the battery device 10 are connected in parallel, and the first battery pack 101 and the second battery pack 102 are connected in parallel so as to supply power to the electrical device 30; or alternatively, the first battery pack 101 and the second battery pack 102 are connected in parallel so as to obtain electric energy from the charging device 30. Furthermore, the control device 210 may send a control signal to the connection state transition device 200, in order that the control connection state transition device 200 transitions from the first connection state shown in FIG. 3 (a) to the second connection state shown in FIG. 2 (a) in response to detecting the control signal, with reference to the relevant description of FIG. 2, the first battery pack 101 and the second battery pack 102 are connected in series so as to supply power for the electrical device 30. As an alternative, the first battery pack 101 and the second battery pack 102 are connected in series so as to obtain electric energy from the charging device 30.

Due to the fact that the first battery pack 101 and second battery pack 102 of the battery device 10 exhibit different electrical characteristics such as providing different voltages, when they are operating in series connection state or in a parallel connection state. Thus, the battery management device 20 provided in one or more embodiments of the present disclosure can control the connection state transition device 200 to transition its connection state, such that the first battery pack 101 and second battery pack 102 of the battery device 10 connected to the connection state transition device 200 can transition from the series connection state to the parallel connection state, and/or the first battery pack 101 and second battery pack 102 of the battery device 10 connected to the connection state transition device 200 can transition from the parallel connection state to the series connection state. Thus, the battery device 10 can be applied to different operating environments, it is desirable to improve of the compatibility of the battery device in terms of charging input and/or power output, and the technical problem of incompatibility of the battery device with different voltage platforms has been solved.

In one selectable embodiment, the control device 210 is further configured to obtain operating environment information of the battery device 10, and the control device 10 controls the connection state transition device 200 to transition from the first connection state to the second connection state according to the operating environment information. Optionally, the operating environment information includes an operating environment voltage and/or an operating environment current. The operating environment voltage and the operating environment current may include an operating environment voltage and an operating environment current of the electrical device. As an example, the connection state transition device 200 of the battery management device 20 is in the connection state shown in FIG. 2 (a), thus, the first battery pack 101 and the second battery pack 102 of the battery device 10 are connected in series to a first electrical device 30 and supply electric energy for the first electrical device 30. When the battery device 10 needs to connect to a second electrical device 30 and supplies electric energy to the second electrical device 30, the control device 210 may obtain the operating environment information of the battery device 10. For example, the operating environment information includes the operating environment voltage of the second electrical device 30. The control device 210 may control the connection state transition device 200 to transition from the connection state shown in FIG. 2 (a) to the connection state shown in FIG. 3 (a) when determining that the first battery pack 101 and the second battery pack 102 are connected in parallel and the output voltage matches with an operating environment voltage of the second electric device 30. After the state conversion is completed, the first battery pack 101 and the second battery pack 102 of the battery device 10 are connected in parallel to the second electrical device 30 and provide electric energy for the second electrical device 30. Optionally, the operating environment information includes operation mode information. For example, the operation mode information may indicate that the first battery pack 101 and the second battery pack are connected in series or in parallel, and may further indicate that the connection state of the connection state transition device 200 is the first connection state or the second connection state. As an example, the operation mode information is preset. For example, a preset sequence is included, for example, a preset identifier is included. After obtaining the operation mode information, the control device 210 controls the connection state transition device 200 to transition from the first connection state to the second connection state. In this embodiment, the connection state transition device 200 may be controlled to transition its connection state according to the operating environment information, which means that, the first battery pack 101 and the second battery pack 102 of the battery device 10 are controlled to transition the connection state, such that the battery device 10 can be more compatible with the operating environment.

In one selectable embodiment, a nominal voltage of the first battery pack 101 is the same as a nominal voltage of the second battery pack 102. The person of ordinary skill in the art can understand that, the nominal voltage, also referred to as the rated voltage, generally refers to an output voltage of the battery pack. The nominal voltage is not the voltage actually output by the battery pack, the actual voltage of the battery pack is related to factors such as battery capacity. Since the nominal voltages of the first battery pack 101 is the same as the second battery pack 102, an output voltage equaling twice of the nominal voltage is generated when the first battery pack 101 and the second battery pack 102 are in connected in series, and an output voltage equaling to the nominal voltage is generated when the first battery pack 101 and the second battery pack 102 are connected in parallel. Thus, when the battery device 10 including the first battery pack 101 and the second battery pack 102 is transitioned from the series connection state to the parallel connection state or transitioned from the parallel connection state to the series connection state, the battery device 10 can be applied to different voltage environments. For example, the battery device 10 can be applied to a voltage platform corresponding to a nominal voltage, and can also be applied to a voltage platform corresponding to twice of the nominal voltage.

Optionally, the operating environment information includes an operating environment voltage, and the control device is further configured to control the connection state transition device to transition from the first connection state to the second connection state when determining that the operating environment voltage matches the nominal voltage. In one selectable embodiment, the operating environment voltage includes an operating voltage of the charging device, a negative electrode of the first battery pack and a positive electrode of the second battery pack are connected to the charging device. The control device is further configured to control the charging device to charge the battery device. As an example, both the nominal voltage of the first battery pack 101 and the nominal voltage of the second battery pack 102 of the battery device 10 are 400V, the battery device 10, the battery management device 20, and the electrical device 30 are connected through the connection manner shown in FIG. 1. Where, for example, the motor of the electric vehicle is applied to or corresponds to 800V voltage platform, thus, the connection state transition device 200 of the battery management device 20 is in the connection state shown in FIG. 2 (a), and the first battery pack 101 and the second battery pack 102 of the battery device 10 are connected in series so as to provide an output voltage of 800V When the electric vehicle needs to be charged by the charging device, the battery device 10, the battery management device 20, and the charging device are connected through the connection manner shown in FIG. 1. Where the negative electrode of the first battery pack 101 and the positive electrode of the second battery pack 102 are connected to the charging device, the control device 210 obtains the operating environment voltage, such as the operating voltage of the charging device. When determining that the operating voltage and the adaptive voltage range of the charging device, or the voltage platform corresponding to the charging device matches with the nominal voltage of the first battery pack 101 and the second battery pack 102, the control device 210 controls the connection state transition device 200 to transition from the connection state shown in FIG. 2 (a) to the connection state shown in FIG. 3 (a), such that the first battery pack 101 and the second battery pack 102 of the battery device 10 are transitioned from a series connection mode to a parallel connection mode. Thus, the first battery pack 101 and the second battery pack 102 of the battery device 10 are connected in parallel so as to provide an output voltage of about 400V In this way, the battery device 10 is applied to the aforementioned charging device and can supply electric energy for the electric vehicle through the aforementioned charging device. Thus, the control device 210 can control the charging device to charge the battery device 10.

Optionally, the operating environment information includes an operating environment voltage, and the control device is further configured to control the connection state transition device to transition from the first connection state to the second connection state when determining that the operating environment voltage matches twice of the nominal voltage. In one selectable embodiment, the operating environment voltage includes an operating voltage of the electrical device, a negative electrode of the first battery pack and a positive electrode of the second battery pack are connected to the electrical device, and the control device is further configured to control the battery device to supply power to the electrical device. As an example, both the nominal voltage of the first battery pack 101 and the nominal voltage of the second battery pack 102 of the battery device 10 are 400V, the battery device 10, the battery management device 20, and the electrical device 30 are connected through the connection manner shown in FIG. 1. Where, the electrical device 30 is, such as the motor of the first electric vehicle, and the motor of the first electric vehicle is applied to or corresponds to 400V voltage platform. Thus, the connection state transition device 200 of the battery management device 20 is in the connection state shown in FIG. 3 (a), and the first battery pack 101 and the second battery pack 102 of the battery device 10 are connected in parallel so as to provide an output voltage of 400V In this way, the battery device 10 is applied to the motor of the first electric vehicle and can provide electric energy for the electric vehicle. When the battery device 10 is applied to the second electric vehicle, the battery device 10, the battery management device 20, and the electric motor of the second electric vehicle are connected through the connection manner shown in FIG. 1. Where, the negative electrode of the first battery pack 101 and the positive electrode of the second battery pack 102 are connected to the electric motor of the second electric vehicle. When the battery device 10 needs to provide electric energy to the electrical device (i.e., the electric motor of the second electric vehicle), the control device 210 obtains the operating environment voltage, such as obtains the operating voltage of the electric motor of the second electric vehicle. When determining that the operating voltage, the adaptive voltage range or the voltage platform corresponding to the electrical device matches with twice of nominal voltage (i.e., 800V) of the first battery pack 101 and the second battery pack 102, the control device 210 controls the connection state transition device 200 to transition from the connection state shown in FIG. 3 (a) to the connection state shown in FIG. 2 (a), in order that the first battery pack 101 and the second battery pack 102 of the battery device 10 transition from the parallel connection mode to the series connection mode. Thus, the first battery pack 101 and the second battery pack 102 of the battery device 10 are connected in series so as to provide an output voltage of about 800V In this way, the battery device 10 is suitable for the electric motor of the second electric vehicle, and the control device 210 can control the battery device 10 to supply electric energy to the electric motor of the second electric vehicle.

In one selectable embodiment, the connection state transition device includes a detection unit and a switching on-off unit. The control device is further configured to send a control signal to the connection state transition device. The detection unit is configured to drive the switching on-off unit to move from a first position to a second position in response to detecting the control signal. When the switching on-off unit is located at the first position, the connection state transition device is in the first connection state; when the switching on-off unit is located at the second position, the connection state transition device is in the second connection state. As described above, the control device 210 may send the control signal to the connection state transition device 200, in order that the connection state transition device 200 transitions from the first connection state to the second connection state in response to detecting the control signal. Regarding the implementation manner of transmitting of the control signal, reference can be made to the descriptions discussed above, the implementation manner of transmitting of the control signal is not repeatedly described herein. The connection state transition device 200 may implement the function of transitioning from one connection state to another connection state through the detection unit and the switching on-off unit.

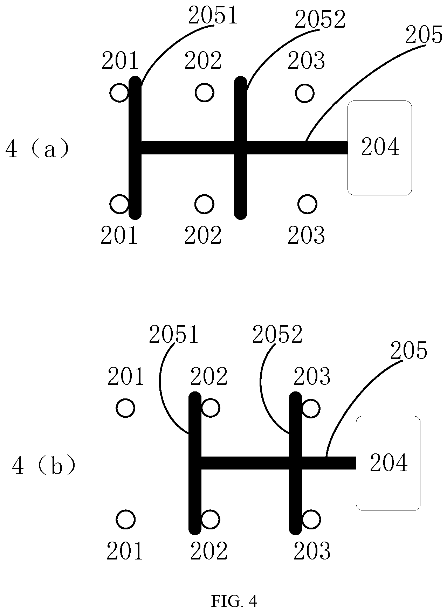

FIG. 4 illustrates a schematic diagram of an operating state of the connection state transition device provided in one or multiple embodiments of the present disclosure. Where, FIG. 4 (a) illustrates a connection state of the connection state transition device 200, in the FIG. 4 (a), the connection state includes: the first pair of contacts 201 is switched on, the second pair of contacts 202 is switched off, the third pair of contacts 202 is switched off. FIG. 4 (b) illustrates another connection state of the connection state transition device 200, and in FIG. 4 (b), the another connection state includes: the first pair of contacts 201 is switched off, the second pair of contacts 202 is switched on, and the third pair of contacts 203 is switched on. The present disclosure is described by taking the first connection state of the connection state transition device 200 including the connection state shown in FIG. 4 (a), and the second connection state of the connection state transition device 200 including the connection state shown in FIG. 4 (b) as an example. Referring to FIG. 4 (a), the connection state transition device 200 includes a first pair of contacts 201, a second pair of contacts 202, a third pair of contacts 203, and a detection unit 204 and a switching on-off unit 205. Where the switching on-off unit 205 is located at a first position. The switching on-off unit 205 can make the first pair of contacts 201 to be switched on and cannot make the second pair of contacts 202 and the third pair of contacts 203 to be switched on when it is located at the first position. Thus, the first pair of contacts 201 are in a switched on state, the second pair of contacts 202 are in a switched off state, and the third pair of contacts 203 are also in the switched off state. The detection unit 204 drives the switching on-off unit 205 to move from the first position shown in FIG. 4 (a) to the second position shown in FIG. 4 (b) in response to detecting the control signal. Referring to FIG. 4 (b), where the switching on-off unit 205 is in the second position, when the switching on-off unit 205 is in the second position, the switching on-off unit 205 cannot make the first pair of contacts 201 to be switched on, but can make the second pair of contacts 202 and the third pair of contacts 203 to be switched on. Thus, the first pair of contacts 201 are in the switched off state, the second pair of contacts 202 are in the switched on state, and the third pair of contacts 203 are also in the switched on state. Optionally, the connection state transition device 200 includes a relay or a contactor. As an example, the connection state transition device 200 includes a multi-contact electromagnetic relay, and the detection unit 204 connected to the state conversion device 200 includes an electromagnetic mechanism (the person of ordinary skill in the art can understand that a common electromagnetic mechanism can control the switching on-off unit to implement opening and closing function of the electromagnetic relay according to electromagnetic force and elastic element). The control signal is, for example, an electrified electric signal. When the detection unit 204 does not detect the control signal, the switching on-off unit 205 is located at the first position shown in FIG. 4 (a). When the switching on-off unit 205 is located at the first position, a first connecting part 2051 of the switching on-off unit 205 is in contact with the first pair of contacts 201 so as to make the first pair of contacts 201 to be switched on. The switching on-off unit 205 further includes a second connecting part 2052, and the second connecting part 2052 is not in contact with the first pair of contacts 201, the second pair of contacts 202, and the third pair of contacts 203. Thus, the second pair of contacts 202 and the third pair of contacts 203 are not switched on. When the control device 210 of the battery management device 20 sends the control signal in order to, for example, energize the circuit corresponding to the detection unit 204, the detection unit 204 of the connection state conversion device 200 (which includes the electromagnetic mechanism) generates an electromagnetic force in response to detecting energization of the circuit, the switching on-off unit 205 is driven to move from the first position shown in Figure 4 (a) to the second position shown in Figure 4 (b). When the switching on-off unit 205 is located at the second position, the first connecting part 2051 of the switching on-off unit 205 is contacted with the second pair of contacts 202, thereby switching on the second pair of contacts 202. The second connecting part 2052 of the switching on-off unit 205 is contacted with the third pair of contacts 203, thereby switching on the second pair of contacts 203. In this condition, the first connecting part 2051 does not contact with the first pair of contacts 201, and thereby not switching on the first pair of contacts 201. In one or more optional embodiments of the present disclosure, the switching on-off unit 205 moves as a whole during the process of moving from the first position to the second position, a more stable switching on and off performance can be achieved during the process of switching on and switching off of the multiple contacts of the connection state transition unit.

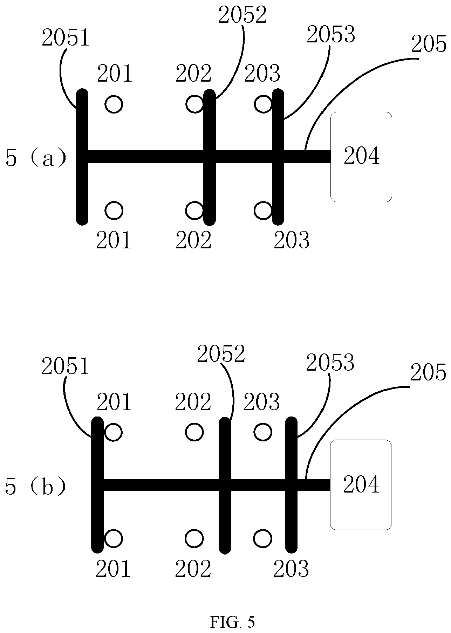

FIG. 5(a) illustrates a schematic diagram of a connection state of another connection state transition device 200 provided in one or multiple embodiments of the present disclosure. Where, FIG. 5(a) illustrates a connection state of the connection state transition device 200. In FIG. 5(a), this connection state includes: the first pair of contacts 201 is switched off, the second pair of contacts 202 is switched on, and the third pair of contacts 202 is switched on. FIG. 5 (b) illustrates another connection state of the connection state transition device 200, in FIG. 5 (b), this connection state includes: the first pair of contacts 201 is switched on, the second pair of contacts 202 is switched off, and the third pair of contacts 203 is switched off. The present disclosure is described by taking the first connection state of the connection state transition device 200 including the connection state shown in FIG. 5 (a), and the second connection state of the connection state transition device 200 including the connection state shown in FIG. 5 (b) as an example. Referring to FIG. 5 (a), the connection state transition device 200 includes a first pair of contacts 201, a second pair of contacts 202, a third pair of contacts 203, a detection unit 204 and a switching on-off unit 205. Where the switching on-off unit 205 is located at the first position, the switching on-off unit 205 does not switch on the first pair of contacts 201, but can switch on the second pair of contacts 202 and the third pair of contacts 203 when it is located at the first position. Thus, the first pair of contacts 201 is in a switched off state, the second pair of contacts 202 is in a switched on state, and the third pair of contacts 203 are also in a switched on state. The detection unit 204 drives the switching on-off unit 205 to move from the first position shown in FIG. 5 (a) to the second position shown in FIG. 5 (b) in response to detecting the control signal. Referring to FIG. 5 (b), where the switching on-off unit 205 is located at the second position, when the switching on-off unit 205 is located at the second position, the switching on-off unit 205 can switch on the first pair of contacts 201, and does not switch on the second pair of contacts 202 and the third pair of contacts 203. Thus, the first pair of contacts 201 is in the switched on state, the second pair of contacts 202 is in the switched off state, and the third pair of contacts 203 is also in the switched off state. Optionally, the connection state transition device 200 includes a relay or a contactor. As one example, the connection state transition device 200 includes a multi-contact electromagnetic relay, the detection unit 204 of the connection state transition device 200 includes an electromagnetic mechanism, and the control signal includes, for example, a power-off signal. The detection unit 204 (which includes the electromagnetic mechanism) generates an electromagnetic force when the corresponding circuit is energized, thereby causing the switching on-off unit 205 to be located at the first position shown in Figure 5 (a). When the switching on-off unit 205 is located at the first position, the first connecting part 2051 of the switching on-off unit 205 does not contact with the first pair of contact points 201, thereby failing to switch on the first pair of contact points 201. The switching on-off unit 205 further includes a second connecting part 2052 and a third connecting part 2053. The second connecting part 2052 contacts the second pair of contacts 202 so as to switch on the second pair of contacts 202, and the third connecting part 2053 contacts with the third pair of contacts 203 so as to switch on the third pair of contacts 203. When the control device 210 of the battery management device 20 sends a control signal in order to, for example, deenergize the circuit corresponding to the detection unit 204. Thus, the detection unit 204 of the connection state transition device 200 (which includes the electromagnetic mechanism) drives the switching on-off unit 205 to move from the first position shown in Figure 5 (a) to the second position shown in Figure 5 (b) in response to detecting deenergization of the circuit and disappearing of the electromagnetic force. When the switching on-off unit 205 is located at the second position, the first connecting part 2051 of the conducting unit 205 is contacted with the first pair of contacts 201, thereby switching on the first pair of contacts 201. The second connecting part 2052 does not contact with the second pair of contacts 202, thereby failing to switch on the second pair of contacts 202. The third connecting part 2053 does not contact with the third pair of contacts 203, thereby failing to switch on the third pair of contacts 203. In one or more optional embodiments of the present disclosure, the switching on-off unit 205 moves as a whole during the process of moving from the first position to the second position, and a more stable switching on and off performance is achieved during the process of switching on and switching off of the multiple contacts of the connection state transition unit.

A battery system is further provided in the embodiments of the present disclosure. The battery system may include the battery management device 20 in one or multiple embodiments described above. The battery system may further include the battery device 10 in one or multiple embodiments as described above. For example, the battery device 10 includes the first battery pack 101 and the second battery pack 102 in one or multiple embodiments as described above. Where, regarding the connection mode between the battery device 10 and the battery management device 20, reference can be made to the connection mode between the battery device 10 and the battery management device 20 in FIG. 1. The connection mode between the battery device 10 and the battery management device 20 is not repeatedly described herein.

A connection state transition device is further provided in the embodiments of the present disclosure. The connection state transition device may include the connection state transition device 200 in one or multiple embodiments described above, and the connection state transition device may be used to connect to the battery device 10 in one or multiple embodiments as described above. The battery device 10 includes the first battery pack 101 and the second battery pack 102 in one or multiple embodiments as described above. Thus, the connection state transition device can change its connection state so as to change the connection state of the battery device 10. For example, the first battery pack 101 and the second battery pack 102 can transition between a series connection state and a parallel connection state.

A battery device is further provided in the embodiments of the present disclosure. The battery device may include a first battery pack and a second battery pack, and the battery device may further include the connection state transition device 200 in one or multiple embodiments described above. Where, regarding the connection mode between the first battery pack and the second battery pack of the connection state transition device 200, reference can be made to the connection mode between the first battery pack 101 and the second battery pack 102 of the connection state transition device 200 in one or multiple embodiments described above. Thus, the connection state transition device 200 can change its connection state so as to change the connection state of the battery device. For example, the first battery pack and the second battery pack can transition between the series connection state and the parallel connection state. For example, the connection state transition device changes the connection state thereof in response to a control signal of a battery management system (BMS) arranged at the exterior of the battery device.

An electric vehicle is further provided in the embodiments of the present disclosure. The electric vehicle may include one or more of the battery device, the battery management device, and the connection state transition device provided in one or multiple embodiments of the present disclosure.

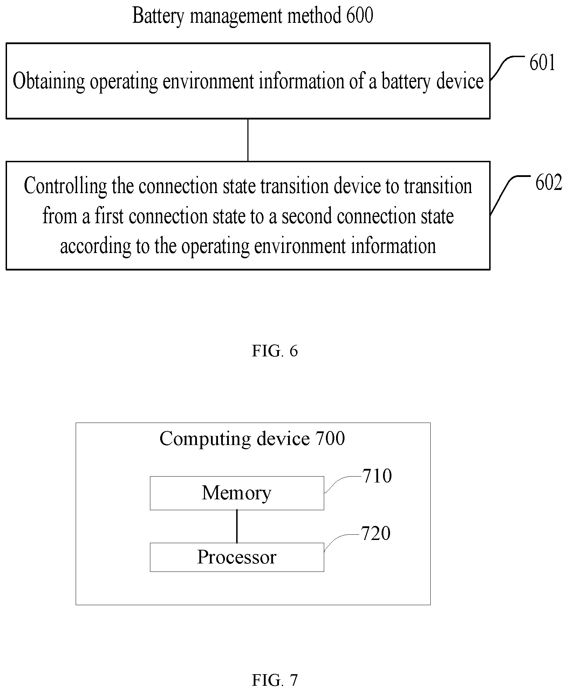

A battery management method is further provided in the embodiments of the present disclosure. FIG. 6 illustrates a schematic flow diagram of the battery management method provided in the present disclosure. It should be understood that the steps or operations in FIG. 6 are merely illustrative, other operations or the variations of the various operations shown in FIG. 6 may be further performed in the embodiments of the present disclosure. In addition, the various steps in FIG. 6 may be executed in orders different from the order shown in FIG. 6, respectively, and it is possible that not all operations in FIG. 6 must be performed.

The method 600 shown in FIG. 6 may be applied to the battery management device, such as the battery management device 20 in one or multiple embodiments described above. The method 600 will be described below. However, it should be understood that the embodiments of the present disclosure are not limited thereto. For example, the battery management device 20 which the method 600 is applied to includes a connection state transition device 200. The connection state transition device 200 includes a first pair of contacts 201, a second pair of contacts 202, and a third pair of contacts 203. One contact in the first pair of contacts 201 is configured to connect to a positive electrode of a first battery pack 101 of a battery device 10, and the other contact in the first pair of contacts 201 is configured to connect to a negative electrode of a second battery pack 102 of the battery device 10. One contact in the second pair of contacts 202 is configured to connect to the positive electrode of the first battery pack 101, and the other contact in the second pair of contacts 202 is configured to connect to the positive electrode of the second battery pack 102. One contact in the third pair of contacts 203 is configured to connect to the negative electrode of the first battery pack 101, and the other contact in the third pair of contacts 203 is configured to connect to the negative electrode of the second battery pack 102. Furthermore, the positive electrode and the negative electrode of the battery device 10 may be connected to the charging device/the electrical device 30, thereby supplying power to the electrical device or performing charging through the charging device. The method 600 includes the following steps:

In a step of S601, environment information of the battery device is obtained.

At the step S601, for example, the battery management device 20 may obtain the operating environment information of the battery device 10. As an example, the operating environment information includes an operating environment voltage and/or an operating environment current. The operating environment voltage and the operating environment current may include an operating environment voltage and an operating environment current of the electrical device 30, and may also include an operating environment voltage and an operating environment current of the charging device 30. Regarding the operating environment information of the battery device, reference can be made to the descriptions in the one or multiple embodiments described above, the detail of the operating environment information of the battery device are not repeatedly described herein.

In a step of S602, the connection state transition device is controlled to transition from a first connection state to a second connection state according to the operating environment information.

At the step S602, for example, the battery management device 20 may control the connection state transition device 200 of the battery management device to transition from the first connection state to the second connection state according to the obtained operating environment information. In one selectable embodiment, the first connection state includes: the first pair of contacts 201 is switched on, the second pair of contacts 202 is switched off, the third pair of contacts 203 is switched off. The second connection state includes: the first pair of contacts 201 is switched off, the second pair of contacts 202 is switched on, and the third pair of contacts 203 is switched on. In another optional embodiment, the first connection state includes: the first pair of contacts 201 is switched off, the second pair of contacts 202 is switched on, and the third pair of contacts 203 is switched on. The second connection state includes: the first pair of contacts 201 is switched on, the second pair of contacts 202 is switched off, and the third pair of contacts 203 is switched off. As an example, the connection state transition device 200 of the battery management device 20 is in the first connection state, the battery management device obtains voltage platform information corresponding to an electrical device 30 (e.g., an electric motor of the electric vehicle) and enables the connection state transition device 200 to be transitioned from the first connection state to the second connection state according to the obtained voltage platform information. As yet another example, the connection state transition device 200 of the battery management device 20 is in the second connection state, and the battery management device obtains the voltage platform information corresponding to the charging device 30 (e.g., a charging pile), and enables the connection state transition device 200 to be transitioned from the second connection state to the first connection state according to the obtained voltage platform information. Regarding the implementation method regarding how the battery management device 20 controls the connection state transition device 200 to transition the connection state, reference can be made to the one or multiple embodiments described above. For example, the battery management device 20 may implement the functions of the control device 210 and/or perform corresponding steps, the detail of the implementation method is not repeatedly described herein.

Due to the fact that the first battery pack 101 and second battery pack 102 of the battery device 10 exhibit different electrical characteristics such as providing different voltages, when they are operating in series connection state or in a parallel connection state. Thus, the battery management method provided in one or more embodiments of the present disclosure can control the connection state transition device 200 to transition its connection state, such that the first battery pack 101 and second battery pack 102 of the battery device 10 connected to the connection state transition device 200 can transition from the series connection state to the parallel connection state, and/or the first battery pack 101 and second battery pack 102 of the battery device 10 connected to the connection state transition device 200 can transition from the parallel connection state to the series connection state. Thus, the battery device 10 can be applied to different operating environments, it is desirable to improve the compatibility of the battery device in terms of charging input and/or power output, and the technical problem of incompatibility of the battery device with different voltage platforms has been solved.

In one selectable embodiment, the operating environment information includes an operating environment voltage, and a nominal voltage of the first battery pack 101 is the same as a nominal voltage of the second battery pack 102. This method 600 further includes controlling the connection state transition device 200 to transition from the first connection state to the second connection state when determining that the operating environment voltage matches the nominal voltage. As an alternative, the method 600 further includes: controlling the connection state transition device 200 to transition from the first connection state to the second connection state when determining that the operating environment voltage matches twice of the nominal voltage. Regarding the implementation methods on how to determine that the operating environment voltage matches with the nominal voltage, and how to determine the operating environment voltage matches with the nominal voltage twice, reference can be made to the descriptions in the one or multiple embodiments described above. The details of the implementation method are not repeatedly described herein.

Optionally, the operating environment voltage includes the operating voltage of the charging device 30, the negative electrode of the first battery pack 101 and the positive electrode of the second battery pack 102 are connected to the charging device 30. For example, after the battery management device 20 controls the connection state transition device 200 to transition from the first connection state to the second connection state, the method 600 further includes: controlling the charging device 30 to charge the battery device 10. Optionally, the operating environment voltage includes the operating voltage of the electrical device 30, the negative electrode of the first battery pack 101 and the positive electrode of the second battery pack 102 are connected to the electrical device 30. For example, after the battery management device 20 controls the connection state transition device 200 to transition from the first connection state to the second connection state, the method 600 further includes: controlling the battery device 10 to supply power to the electrical device 30. Regarding the implementation on how to supply power to the electrical device 30 and/or charging the battery device 10 through the charging device 30 after transition of the connection state, reference can be made to the descriptions in one or multiple embodiments described above. The implementation on how to supply power to the electrical device 30 and/or charging the battery device 10 through the charging device 30 after transition of the connection state are not repeatedly described herein.

In one selectable embodiment, the connection state transition device 200 includes a detection unit 204 and a switching on-off unit 205, and the method 600 further includes: transmitting a control signal to the connection state transition device 200 according to the operating environment information, in order that the detection unit 204 drives the switching on-off unit 205 to move from the first position to the second position in response to detecting the control signal. When the switching on-off unit 205 is located at the first position, the connection state transition device 200 is in the first connection state; when the switching on-off unit 205 is located at the second position, the connection state transition device 200 is in the second connection state. Optionally, the switching on-off unit 205 includes a first connecting part 2051 and a second connecting part 2052. For example, when the switching on-off unit 205 is in the first position shown in FIG. 4 (a), the first connecting part 2051 contacts with the first pair of contacts 201, thereby switching on the first pair of contacts 201. The second connecting part does not contact with the first pair of contacts 201, the second pair of contacts 202 and the third pair of contacts 203, and thereby failing to switch on the second pair of contacts 202 and the third pair of contacts 203. When the battery management device 20 transmits the control signal, and the detection unit 204 connected to the connection state transition device 200 drives the switching on-off unit 205 to move from the first position shown in FIG. 4 (a) to the second position shown in FIG. 4 (b) in response to detecting the control signal. When the switching on-off unit 205 is located at the second position, the first connection part 2051 of the switching on-off unit 205 contacts with the second pair of contacts 202 to switch on the second pair of contacts 202, and the second connection part 2052 of the switching on-off unit 205 contacts with the third pair of contacts 203, thereby switching on the second pair of contacts 203. In this condition, the first connecting part 2051 does not contact with the first pair of contacts 201, thereby failing to switch on the first pair of contacts 201. Regarding the implementation on how to enable the detection unit 204 to drive the switching on-off unit 205 to move from the first position to the second position in response to detecting the control signal, reference can be made to the one or multiple embodiments described above. The implementation on how to enable the detection unit 204 to drive the switching on-off unit 205 to move from the first position to the second position in response to detecting the control signal is not repeatedly described herein.

FIG. 7 illustrates a schematic block diagram of a computer device 700 according to one selectable embodiment of the present disclosure. As shown in FIG. 7, the computer device 700 includes a memory 710 and a processor 720, where the memory 710 is coupled to the processor 720. The memory 710 is configured to store a program instruction, and the processor 720 is configured to invoke the program instruction stored in the memory 710, in order to perform the method in the various embodiments of the present disclosure.

A computer-readable storage medium is further provided in the embodiments of the present disclosure, the computer-readable storage medium is configured to store a computer program, and the computer program is configured to perform the method in the various embodiments of the present disclosure.

As stated above, it should be noted that, the foregoing embodiments are only intended to explain the technical solutions of the present application, rather than limiting the technical solutions of the present application. Although the present application has been described in detail with reference to the embodiments described above, a person of ordinary skilled in the art should understand that, the technical solutions disclosed in the embodiments may also be amended, some technical features in the technical solutions may also be equivalently replaced. The amendments or the equivalent replacements don't cause the essence of the corresponding technical solutions to be deviated from the spirit and the scope of the technical solutions in the embodiments of the present application, and thus should all be included in the protection scope of the present application.

## Claims

1. A battery management device, configured to manage a battery device, **characterized in that**, the battery management device comprises:
a control device and a connection state transition device;
the connection state transition device includes a first pair of contacts, a second pair of contacts, and a third pair of contacts;
one contact in the first pair of contacts is configured to connect to a positive electrode of a first battery pack of the battery device, and the other contact in the first pair of contacts is configured to connect to a negative electrode of a second battery pack of the battery device;
one contact in the second pair of contacts is configured to connect to the positive electrode of the first battery pack, and the other contact in the second pair of contacts is configured to connect to a positive electrode of the second battery pack;
one contact in the third pair of contacts is configured to connect to a negative electrode of the first battery pack, and the other contact in the third pair of contacts is configured to connect to the negative electrode of the second battery pack;
the control device is configured to control the connection state transition device to transition from a first connection state to a second connection state;
the first connection state comprises: the first pair of contacts is switched on, the second pair of contacts is switched off, and the third pair of contacts is switched off; the second connection state comprises: the first pair of contacts is switched off, the second pair of contacts is switched on, and the third pair of contacts is switched on; or alternatively,
the first connection state comprises: the first pair of contacts is switched off, the second pair of contacts is switched on, and the third pair of contacts is switched on; the second connection state comprises: the first pair of contacts is switched on, the second pair of contacts is switched off, and the third pair of contacts is switched off.

2. The battery management device according to claim 1, wherein the control device is further configured to obtain operating environment information of the battery device;
the control device is further configured to control the connection state transition device to transition from the first connection state to the second connection state according to the operating environment information.

3. The battery management device according to claim 2, wherein the operating environment information includes an operating environment voltage, a nominal voltage of the first battery pack is the same as a nominal voltage of the second battery pack;
the control device is further configured to control the connection state transition device to transition from the first connection state to the second connection state when determining that the operating environment voltage matches the nominal voltage.

4. The battery management device according to claim 2, wherein the operating environment information comprises an operating environment voltage, and a nominal voltage of the first battery pack is the same as a nominal voltage of the second battery pack;
the control device is further configured to control the connection state transition device to transition from the first connection state to the second connection state when determining that the operating environment voltage matches twice of the nominal voltage.

5. The battery management device according to claim 3 or claim 4, wherein the operating environment voltage comprises an operating voltage of the charging device, the negative electrode of the first battery pack and the positive electrode of the second battery pack are connected to the charging device;
the control device is further configured to control the charging device to charge the battery device.

6. The battery management device according to claim 3 or claim 4, wherein the operating environment voltage comprises an operating voltage of an electrical device, the negative electrode of the first battery pack and the positive electrode of the second battery pack are connected to the electrical device;
the control device is further configured to control the battery device to supply power to the electrical device.

7. The battery management device according to any one of claims 1-4, wherein the connection state transition device comprises a detection unit and a switching on-off unit;
the control device is further configured to transmit a control signal to the connection state transition device;
the detection unit is configured to drive the switching on-off unit to move from a first position to a second position in response to detecting the control signal;
when the switching on-off unit is located at the first position, the connection state transition device is in the first connection state;
when the switching on-off unit is located at the second position, the connection state transition device is in the second connection state.

8. A battery system, **characterized in that**, the battery system comprises the battery management device according to any one of claims 1-7, the battery system further comprises the battery device.

9. A battery management method, being applied to a battery management device for realizing management of a battery device, **characterized in that**, the battery management device comprises a connection state transition device; the connection state transition device includes a first pair of contacts, a second pair of contacts, and a third pair of contacts; one contact in the first pair of contacts is configured to connect to a positive electrode of a first battery pack of the battery device, the other contact in the first pair of contacts is configured to connect to a negative electrode of a second battery pack of the battery device; one contact in the second pair of contacts is configured to connect to the positive electrode of the first battery pack, the other contact in the second pair of contacts is configured to connect to a positive electrode of the second battery pack; one contact in the third pair of contacts is configured to connect to a negative electrode of the first battery pack, and the other contact in the third pair of contacts is configured to connect to the negative electrode of the second battery pack; a first connection state of the connection state transition device comprises: the first pair of contacts is switched on, the second pair of contacts is switched off, and the third pair of contacts is switched off; the second connection state of the connection state transition device comprises: the first pair of contacts is switched off, the second pair of contacts is switched on, and the third pair of contacts is switched on; as an alternative, the first connection state comprises: the first pair of contacts is switched off, the second pair of contacts is switched on, and the third pair of contacts is switched on; the second connection state comprises: the first pair of contacts is switched on, the second pair of contacts is switched off, and the third pair of contacts is switched off; the method comprises:
obtaining operating environment information of the battery device; and
controlling the connection state transition device to transition from the first connection state to the second connection state according to the operating environment information.

10. The battery management method according to claim 9, wherein the operating environment information comprises an operating environment voltage, and a nominal voltage of the first battery pack is the same as a nominal voltage of the second battery pack;
said controlling the connection state transition device to transition from the first connection state to the second connection state according to the operating environment information comprises:
controlling the connection state transition device to transition from the first connection state to the second connection state, when determining that the operating environment voltage matches the nominal voltage.

11. The battery management method according to claim 9, wherein the operating environment information comprises an operating environment voltage, and a nominal voltage of the first battery pack is the same as a nominal voltage of the second battery pack;
said controlling the connection state transition device to transition from the first connection state to the second connection state according to the operating environment information comprises:
controlling the connection state transition device to transition from the first connection state to the second connection state, when determining that the operating environment voltage matches twice of the nominal voltage.

12. The battery management method according to claim 10 or claim 11, wherein the operating environment voltage comprises an operating voltage of the charging device, a negative electrode of the first battery pack and a positive electrode of the second battery pack are connected to the charging device;
after controlling the connection state transition device to transition from the first connection state to the second connection state, the method further comprises: controlling the charging device to charge the battery device.

13. The battery management method according to claim 10 or claim 11, wherein the operating environment voltage comprises an operating voltage of an electrical device, a negative electrode of the first battery pack and a positive electrode of the second battery pack are connected into the electrical device;
after controlling the connection state transition device to transition from the first connection state to the second connection state, the method further comprises: controlling the battery device to supply power to the electrical device.

14. The battery management method according to any one of claims 9-11, wherein the connection state transition device comprises a detection unit and a switching on-off unit;
said controlling the connection state transition device to transition from the first connection state to the second connection state according to the operating environment information comprises: sending a control signal to the connection state transition device according to the operating environment information, in order that the detection unit drives the switching on-off unit to move from a first position to a second position in response to detecting the control signal;
when the switching on-off unit is located at the first position, the connection state transition device is in the first connection state;
when the switching on-off unit is located at the second position, the connection state transition device is in the second connection state.

15. A computer device, **characterized in that**, the computer device comprises a processor and a memory, wherein the memory stores a computer instruction, the processor is configured to execute the computer instruction so as to cause the computer device to implement the battery management method according to any one of claims 9-14.

16. A computer-readable storage medium, configured to store a computer instruction, **characterized in that**, the computer instruction is configured to, when being executed by a computer device, causes the computer device to implement the battery management method according to any one of claims 9-14.

17. A connection state transition device, comprising:
a first pair of contacts, a second pair of contacts, a third pair of contacts, and a connection control device;
one contact in the first pair of contacts is configured to connect to a positive electrode of the first battery pack, and the other contact in the first pair of contacts is configured to connect to a negative electrode of the second battery pack;
one contact in the second pair of contacts is configured to connect to the positive electrode of the first battery pack, and the other contact in the second pair of contacts is configured to connect to a positive electrode of the second battery pack;
one contact in the third pair of contacts is configured to connect to a negative electrode of the first battery pack, and the other contact in the third pair of contacts is configured to connect to the negative electrode of the second battery pack;
the connection control device is configured to cause the connection state transition device to transition from the first connection state to the second connection state in response to detecting a control signal;
the first connection state includes: the first pair of contacts is switched on, the second pair of contacts is switched off, and the third pair of contacts is switched off; the second connection state comprises: the first pair of contacts is switched off, the second pair of contacts is switched on, and the third pair of contacts is switched on; or alternatively,
the first connection state comprises: the first pair of contacts is switched off, the second pair of contacts is switched on, and the third pair of contacts is switched on; the second connection state comprises: the first pair of contacts is switched on, the second pair of contacts is switched off, and the third pair of contacts is switched off.

18. A battery device, comprising the connection state transition device according to claim 17, and further comprising the first battery pack and the second battery pack.
